# EUROPÄISCHE PATENTSCHRIFT

(11) **EP 0 996 227 B1**
(45) Veröffentlichungstag und Bekanntmachung des Hinweises auf die Patenterteilung: **06.08.2003**
(21) Anmeldenummer: 99810908.6
(22) Anmeldetag: 06.10.1999
(51) Int. Cl.: H03K 17/082, H03K 17/567, H03K 17/795, H03K 17/08

(54) **Verfahren zur Schaltzustandsüberwachung eines IGBT und Vorrichtung zur Durchführung des Verfahrens**
Method of controlling the switching state of a IGBT and device for carrying out the method
Procédé de contrôle de l'état de commutation d'un IGBT et dispositif pour la mise en oeuvre du procédé

(30) Priorität: 24.10.1998 DE 19849097
(43) Veröffentlichungstag der Anmeldung: 26.04.2000
(73) Patentinhaber: DaimlerChrysler Rail Systems GmbH, 13627 Berlin (DE)
(72) Erfinder: Jörg, Markus, 5424 Unterehrendingen (CH); Umbricht, Stefan, 5417 Untersiggenthal (CH); Enzensberger, Gernot, 5430 Wettingen (CH)
(74) Vertreter: Cohausz & Florack

(56) Entgegenhaltungen:
- EP-A- 0 392 530
- EP-A- 0 413 938
- EP-A- 0 599 455
- EP-A- 0 680 146
- EP-A- 0 703 664
- EP-A- 0 730 348
- EP-A- 0 762 652
- EP-A- 0 797 301
- EP-A- 0 808 024
- DE-A- 19 741 391
- US-A- 4 721 869
- US-A- 5 444 591
- US-A- 5 559 656
- US-A- 5 585 993
- US-A- 5 689 394

## Beschreibung

### Technisches Gebiet

Die Erfindung bezieht sich auf das Gebiet der Leistungselektronik. Sie geht aus von einem Verfahren zur Schaltzustandsüberwachung eines Bipolartransistors mit isoliert angeordneter Gateelektrode (IGBT) und einer Vorrichtung zur Durchführung des Verfahrens gemäss dem Oberbegriff der unabhängigen Ansprüche.

### Stand der Technik

Zur Ansteuerung eines Bipolartransistors mit isoliert angeordneter Gateelektrode (IGBT) wird eine Gateelektrodentreiberstufe (Gate Drive Unit GDU) verwendet. Das "Betriebshandbuch der Gate Drive Unit GV A587 A der ABB Industrie AG" nennt eine gattungsgemässe GDU. Die darin beschriebene GDU erhält von einer Leitelektronik ein Leitbefehlsignal in Form eines Einschalt- oder Ausschaltbefehls über eine elektrische Leitung. Dieses Leitbefehlsignal wird einer logischen Auswerteschaltung in der GDU zugeführt, die das Leitbefehlsignal dahingehend auswertet, ob es sich um einen Einschalt- oder Ausschaltbefehl für den IGBT handelt. Die logische Auswerteschaltung spricht eine Treiberschaltung in der GDU an, die das ausgewertete Signal der logischen Auswerteschaltung in eine entsprechende Gate-Emitterspannung des IGBT umsetzt und so den IGBT ansteuert.

Die GDU ihrerseits erzeugt aus der Gate-Emitterspannung, aus einem eine Speisungsüberwachungsschaltung der GDU erzeugendes Speisungsüberwachungssignal und aus einem eine IGBT-Entsättigungsüberwachungsschaltung der GDU erzeugendes IGBT-Entsättigungssignal ein Rückmeldesignal, das über eine elektrische Leitung zurück zur Leitelektronik übertragen wird.
Im abgeschalteten Zustand des IGBT und bei ungestörtem Berieb der GDU ist das Rückmeldesignal an die Leitelektronik aktiv. Für den eingeschalteten Zustand des IGBT oder bei einer Störung der GDU, insbesondere bei einem Fehler der GDU-Speisung oder bei einer Entsättigung des IGBT liefert die GDU ein passives Rückmeldesignal an die Leitelektronik.

Die heutige Schaltzustandsüberwachung eines IGBT basiert auf der Überwachung der Gate-Emitterspannung und wiederspiegelt daher nachteiligerweise nicht die tatsächlichen Schaltzustände des IGBT im Hauptstrompfad zwischen dem Kollektor und dem Emitter. Eine Überwachung zwischen dem tatsächlichen Schaltzustand des IGBT im Hauptrompfad (Kollektor-Emitter) und der Ansteuerung mit der Gate-Emmitterspannung ist derzeit somit nicht gegeben und das Rückmeldungssignal lässt damit keine eindeutige Aussage über die Schaltzustände am IGBT zu.
Tritt im Falle eines eingeschalteten IGBT ein Fehler in der GDU auf, so wird das Rückmeldesignal unabhängig vom Schaltzustand des IGBT auf das passive Rückmeldesignals gesetzt. Da aber bereits dem Zustand des eingeschalteten IGBT das passive Rückmeldesignal zugeordnet ist, wird der in der GDU aufgetretene Fehler in der Leitelektronik zunächst nicht erkannt. Erst wenn von der Leitelektronik der Leitbefehl zum Ausschalten des IGBT an die GDU gesendet wird, von dieser jedoch ein passives Rückmeldesignal an die Leitelektronik gesendet wird, kann der Fehler erkannt werden. Dies kann einen Zeitraum beanspruchen, der aus Sicht des Schutzes des IGBT und für beteiligte Schaltungskomponenten nicht akzeptiert werden kann.
Ein eventuell auftretender Fehler im Haupstrompfad des IGBT am Kollektor und Emitter, wie z.B. ein Kurzschluss oder eine Unterbrechung, wird derzeit bei der bestehenden Schaltzustandsüberwachung nicht berücksichtigt oder erfasst.
Desweiteren sind häufig bei Stromrichterschaltungsanwendungen IGBTs mit einer Diode im Hauptstrompfad am Kollektor und Emitter des jeweiligen IGBT, wie beispielsweise in der EP 0 430 044 B1 offenbart, verbunden. Mit der heutigen Schaltzustandsüberwachung eines IGBT wird diese Diode nicht überwacht und ein eventuell auftretender Fehler dieser Diode nicht erkannt.

Die US 5,689,394 betrifft ein gattungsgemäßes Verfahren zur Schaltzustandsüberwachung eines Bipolartransistors, bei dem ein aus der Kollektor-Emitter-Spannung des IGBT gebildetes Rückmeldesignal überwacht wird. Dort wird neben der Gateelektrodentreiberstufe eine externe Steuereinrichtung verwendet, welche im Kurzschlussfall die Gatespannung über eine Pulsweitenmodulation anpasst, um Überströme zu verhindern.

Dieses bekannte gattungsgemäße Verfahren und die bekannte Vorrichtung weisen jedoch den Nachteil auf, dass sie einen zuverlässigen Schutz nur bei einwandfreier Funktion der verwendeten Bauteile, insbesondere der Gateelektrodentreiberstufe bzw. des Bipolartransistors selbst, sicherstellen. Ist diese einwandfreie Funktion nicht gewährleistet, kann es ohne weiteres zu einer Beschädigung des Bipolartransistors oder damit verbundener Bauteile durch Überströme bzw. Überspannungen kommen.

### Darstellung der Erfindung

Der vorliegenden Erfindung liegt daher die Aufgabe zu Grunde, ein Verfahren zur Schaltzustandsüberwachung eines Bipolartransistors zur Verfügung zu stellen, welches in einfacher Weise zusätzlichen Schutz für den Bipolartransistor oder damit verbundene Bauteile sicherstellt. Weiterhin liegt ihr die Aufgabe zu Grunde, eine besonders einfache Vorrichtung zur Durchführung des Verfahrens anzugeben.

Diese Aufgabe wird durch die Merkmale der unabhängigen Ansprüche gelöst.

Beim erfindungsgemässen Verfahren wird aus der Kollektor-Emitterspannung des IGBT ein Rückmeldesignal gebildet und von der Gateelektrodentreiberstufe zur Leitelektronik übertragen. Das Rückmeldesignal wird somit nicht mehr direkt vom Speisungsüberwachungssignal der GDU und dem IGBT-Entsättigungssignal beeinflusst, sondern weist nur die auf einen Schwellwert hin überwachte Kollektor-Emitterspannung auf. Somit werden vorteilhaft Fehler im IGBT, die den Schaltzustand beeinflussen, sofort erkannt und über das Rückmeldesignal der Leitelektronik gemeldet. Desweiteren werden Beschaltungen des IGBT, die mit dem Kollektor und Emitter des IGBT verbunden sind, mit diesem Verfahren der Schaltzustandsüberwachung mit überwacht. Zusätzlich wird der IGBT in diesem erfindungsgemässen Verfahren im Falle eines Speisungsausfalls oder im Falle einer Entsättigung des IGBT selbständig von der GDU angesteuert und in einen sicheren Schaltzustand gebracht.

Die Vorrichtung zur Durchführung des Verfahrens weist einen Schwellwertvergleicher mit einem einstellbaren Schwellwert auf. Der Schwellwertvergleicher vergleicht die Kollektor-Emitterspannung mit dem Schwellwert und gibt das Rückmeldesignal aus. Der Schwellwertvergleicher der GDU gewährleistet, dass das Rückmeldesignal beispielsweise oberhalb des eingestellten Schwellwertes der Kollektor-Emitterspannung als aktiv und unterhalb als nicht aktiv gesetzt wird. Erfindungsgemäss umfasst die Vorrichtung optische Sende- und Empfangsmittel. Dies hat den Vorteil, dass eine potentialtrennende Ankopplung an die GDU mit durchgeführt werden kann.

Das erfindungsgemässe Verfahren der Schaltzustandsüberwachung eines IGBT und die Vorrichtung zur Durchführung des Verfahrens bieten zudem einen verbesserten Schutz des IGBT und eventuell beteiligter Beschaltungen.Gleichzeitig werden Fehler im Haupstrompfad des IGBT, wie beispielsweise Unterbrüche oder Kurzschlüsse, mit überwacht.

### Kurze Beschreibung der Zeichnungen

Nachfolgend wird die Erfindung anhand von Ausführungsbeispielen im Zusammenhang mit Zeichnungen näher erläutert.

Es zeigt:
- **Fig. 1**: Ausführungsform einer Vorrichtung zur Durchführung des Verfahrens der Schaltzustandsüberwachung eines IGBT
- **Fig.2**: Ausführungsbeispiel eines auf seinen Schaltzustand zu überwachender IGBT mit einer Diode am Kollektor und Emitter

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

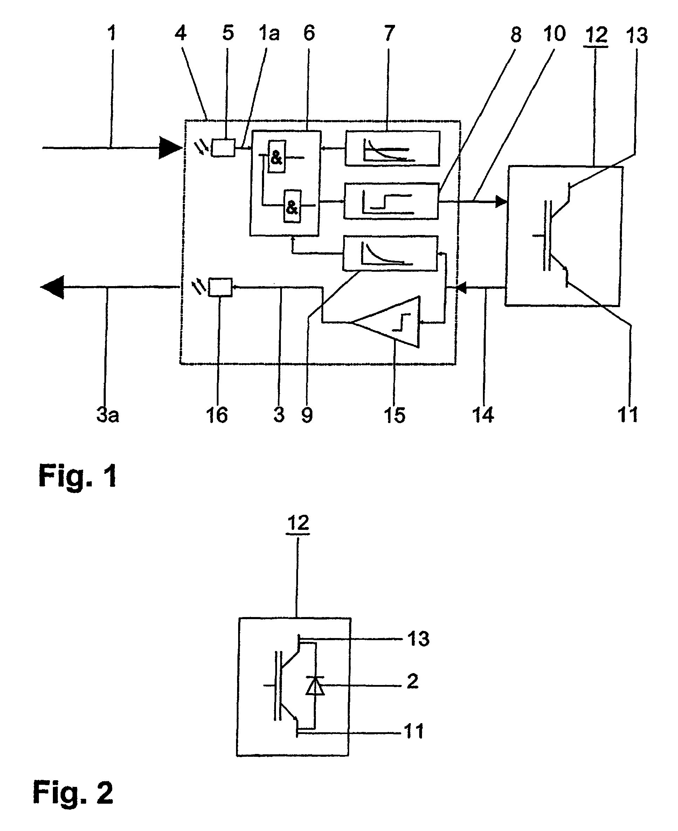

Fig. 1 zeigt eine erfindungsgemässe Ausführungsform der Vorrichtung zur Durchführung des Verfahrens der Schaltzustandsüberwachung eines IGBT 12. Die Vorrichtung in Fig. 1 umfasst eine Gateelektrodentreiberstufe (GDU) 4 und einen anzusteuernden und auf seinen Schaltzustand hin zu überwachenden IGBT 12. Als vorteilhaft hat sich erwiesen, dass die GDU 4 ein optisches Empfangsmittel 5 und ein optisches Sendemittel 16 aufweist. Dadurch kann eine potentialgetrennte Übertragung eines optischen Leitbefehlsignals 1 zu der GDU 4 und eines optischen Rückmeldesignals 3a von der GDU 4 zu einer in Fig.1 nicht eingezeichneten Leitelektronik erreicht werden. Insbesondere wird als optisches Empfangsmittel 5, aufgrund der sehr schnellen Wandlung eines optischen Signals in ein elektrisches Signal, eine Photodiode eingesetzt. Als optisches Sendemittel 16 wird insbesondere eine Licht emittierende Diode oder eine Laserdiode zur schnellen Wandlung eines elektrischen Signals in ein optisches Signal eingesetzt. Ein optisches Sendemittel 16 und optisches Empfangsmittel 5 erweist sich in Bezug auf eine potentialtrennende Ankopplung zwischen der in Fig. 1 nicht dargestellten Leitelektronik und der GDU 4, insbesondere mit Lichtwellenleitern als vorteilhaft. Desweiteren umfasst die GDU 4 eine logische Auswerteschaltung 6 mit einem in Fig. 1 symbolisch dargestellten logischen Netzwerk, eine Speisungsüberwachungsschaltung 7, eine IGBT-Entsättigungsüberwachungsschaltung 9, eine Treiberschaltung 8 und einen Schwellwertvergleicher 15 mit enstellbarem Schwellwert.
Der IGBT 12 weist bei Stromrichterschaltungsanordnungen gängigerweise eine parallele Diode 2 im Haupstrompfad am Kollektor 13 und Emitter 11 auf, wie das Ausführungsbespiel in Fig. 2 zeigt.

Im fehlerfreien Betrieb der Ansteuerung des IGBT 12 erhält die GDU 4 von der nicht dargestellten Leitelektronik ein optisches Leitbefehlsignal 1 in Form eines entsprechenden Einschalt- oder Ausschaltbefehls. Über das eingesetzte optische Empfangsmittel 5 wird das optische Leitbefehlsignal 1 in ein elektrisches Leitbefehlsignal 1a gewandelt und der logischen Auswerteschaltung 6 zugeführt. Die logische Auswerteschaltung 6 wertet das eingegangene elektrische Leitbefehlsignal 1a dahingehend aus, ob es sich dabei um einen Einschalt- oder Ausschaltbefehl handelt und spricht die Treiberschaltung 8 an, die das von der logischen Auswerteschaltung 6 ausgegebene Signal in eine Gate-Emitterspannung 10 umsetzt und somit den IGBT 12 ansteuert.

Erfindungsgemäss wird aus der Kollektor-Emitterspannung 14 des IGBT 12 ein Rückmeldesignal 3, 3a gebildet. Dies wird im folgenden beschrieben. Nach Fig. 1 wird die Kollektor-Emitterspannung 14 des IGBT 12 auf die GDU 4 zurückgeführt. Die Kollektor-Emitterspannung 14 wird zum einen der IGBT-Entsättigungsüberwachungsschaltung 9 zugeführt, die eine etwaige Entsättigung im Fehlerfall seitens des IGBT 12 der logischen Auswerteschaltung auf dem in Fig. 1 gezeigten Signalweg meldet. Desweiteren wird die Kollektor-Emitterspannung 14 auf einen einstellbaren Schwellwert hin im Schwellwertvergleicher 15 überwacht. Liegt die Kollektor-Emitterspannung 14 beispielhaft oberhalb des eingestellten Schwellwertes des Schwellwertvergleichers 15, so wird am Ausgang des Schwellwertvergleichers 15 das elektrische Rückmeldesignal 3 als aktiv gesetzt und im Falle einer unterhalb des eingstellten Schwellwertes des Schwellwertvergleichers 15 liegenden Kollektor-Emitterspannung 14 als nicht aktiv gesetzt. Dieser Schwellwertvergleich der Kollektor-Emitterspannung 14 gewährleistet, dass die Zuordnung zwischen der Kollektor-Emitterspannung 14 und dem Rückmeldesignal 3 um den eingestellten Schwellwert herum eindeutig, entweder als aktives Rückmeldesignal 3 oder als passives Rückmeldesignal 3, gemacht werden kann.
Nach in Fig.1 gezeigter Weise wird das am Ausgang des Schwellwertvergleichers 15 anliegenden elektrische Rückmeldesignal 3 dem optischen Sendemittel 16 zugeführt und in ein optisches Rückmeldesignal 3a gewandelt und zu der nicht dargestellten Leittelektronik übertragen.
Vorteilhaft wirkt sich aus, dass durch die Bildung des Rückmeldesignals 3, 3a aus der Kollektor-Emitterspannung 14 zu jedem gegeben Zeitpunkt der Hauptstrompfad am Kollektor 13 und Emitter 11 des IGBT 12 überwacht wird. Fehler im IGBT, die den Schaltzustand beeinflussen, werden zu jedem gegebenen Zeitpunkt erfasst und in beschriebener Weise mittels des Rückmeldesignals 3, 3a der nicht dargestellten Leitelektronik gemeldet. Zusätzlich werden Fehler im Hauptstrompfad am Kollektor 13 und Emitter 11 des IGBT 12, wie Kurzschlüsse oder Unterbrüche durch dieses erfindungsgemässe Verfahren der Schaltzustandsüberwachung des IGBT 12 erfasst und der nicht dargestellten Leitelektronik mittels des Rückmeldesignals 3, 3a gemeldet. Bei Stromrichterschaltungsanwendungen weist, wie bereits erwähnt, der IGBT 12 gängigerweise die Diode 2 im Hauptstrompfad am Kollektor 13 und Emitter 11 auf. Mit Hilfe des Verfahrens der Schaltzustandsüberwachung des IGBT 12, welches die Bildung des Rückmeldesignals 3, 3a aus der Kollektor-Emitterspannung 14 umfasst, wird vorteilhaft diese Diode 2 mit überwacht.

Das erfindungsgemässe Verfahren der Schaltzustandsüberwachung des IGBT 12 umfasst weiterreichend die selbständige Ansteuerung des IGBT 12 durch die GDU 4. Tritt beispielsweise ein Ausfall der nicht eingezeichneten GDU-Speisung auf, so wird dieser Fehler von der Speisungsüberwachungsschaltung 7 erkannt und der logischen Auswerteschaltung 6 über den in Fig. 1 eingezeicheten Signalweg gemeldet. Unabhängig vom anliegenden elektrischen Leitbefehlsignal 1a spricht die logische Auswerteschaltung 6 die Treiberschaltung 8 an, welche den IGBT 12 über die Gate-Emitterspannung 10 ansteuert und anwendungsabhängig in einen sicheren Schaltzustand versetzt.
Eine Anwendung eines IGBT ist insbesondere eine gängige Stromrichterschaltung, bei der mehrere IGBT zu einem Einphasenbrücke verschalten sind. Der IGBT dieser Stromrichterschaltung, dessen GDU-Speisung ausgefallen ist, wird selbstständig abgeschaltet und somit in einen sicheren Schaltzustand gebracht.
Hingegen wird beispielsweise bei einer gängigen Überspannungsbegrenzungsschaltungsanwendung mit einem IGBT für einen üblichen Gleichspannungszwischenkreis, der eingesetzte IGBT, dessen GDU-Speisung ausgefallen ist, eingeschaltet und somit in diesen sicheren Schaltzustand versetzt, um die im Gleichspannungszwischenkreis gespeicherte Energie abzubauen und dadurch die Spannung im Gleichspannungszwischenkreis zu senken.
Desweiteren wird beispielsweise eine Entsättigung des IGBT 12 von der Entsättigungsüberwachungsschaltung 9 der GDU 4 über die Kollektor-Emitterspannung 14 des IGBT 12 erkannt und der logischen Auswerteschaltung 6 über den in Fig. 1 eingezeicheten Signalweg gemeldet. Auch in diesem Fall spricht die logische Auswerteschaltung 6 die Treiberschaltung 8 an, welche den IGBT 12 über die Gate-Emitterspannung 10 ansteuert und anwendungsabhängig in einen sicheren Schaltzustand versetzt, unabhängig davon welches elektrische Leitbefehlsignal 1a an der logischen Auswerteschaltung 6 anliegt.

Eine selbstständige Ansteuerung des IGBT 12 durch die GDU 4 wird in besonders einfacher Weise durch die logische Auswerteschaltung 6 erreicht, welche je nach Anwendung des IGBT 12 so ausgelegt ist, dass, im Falle einer Entsättigung des IGBT 12 und/oder im Falle eines Speisungsausfalls der GDU 4, der IGBT 12 in seinen jeweils anwendungsabhängigen Schaltzustand gebracht wird um so den Stromrichter vor Schaden oder Zerstörung zu schützen.

### Bezugszeichenliste

- 1: optische Leitbefehlsignal
- 1a: elektrisches Leitbefehlsignal
- 2: Diode
- 3: elektrisches Rückmeldesignal
- 3a: optisches Rückmeldesignal
- 4: Gateelektrodentreiberstufe
- 5: optisches Empfangsmittel
- 6: logische Auswerteschaltung
- 7: Speisungsüberwachungsschaltung
- 8: Treiberschaltung
- 9: IGBT-Entsättigungsüberwachungsschaltung
- 10: Gate-Emitterspannung
- 11: Emitter
- 12: IGBT
- 13: Kollektor
- 14: Kollektor-Emitterspannung
- 15: Schwellwertvergleicher
- 16: optische Sendemittel

## Patentansprüche

1. Verfahren zur Schaltzustandsüberwachung eines Bipolartransistors mit isoliert angeordneter Gateelektrode (IGBT) (12), welcher mittels einer die Gate-Emitterspannung (10) anlegenden Gateelektrodentreiberstufe (4) angesteuert wird und dessen Kollektor-Emitterspannung (14) der Entsättigungsüberwachung des IGBT (12) dient und bei dem von der Gateelektrodentreiberstufe (4) ein Rückmeldesignal (3, 3a) an eine Leitelektronik gesendet wird, wobei aus der Kollektor-Emitterspannung (14) des IGBT (12) das Rückmeldesignal (3) gebildet wird und das Rückmeldesignal (3) auf einen einstellbaren Schwellwert hin überwacht wird, **dadurch gekennzeichnet, dass** im Falle einer Entsättigung des IGBT (12) und/oder im Falle eines Speisungsausfalls der Gateelektrodentreiberstufe (4) der IGBT (12) selbstständig derart angesteuert wird, dass der IGBT (12) anwendungsabhängig in einen sicheren Schaltzustand versetzt wird.

2. Verfahren nach Anspruch 1, **dadurch gekennzeichnet, dass** das Rückmeldesignal als optisches Rückmeldesignal (3a) von der Gateelektrodentreiberstufe (4) zur Leitelektronik übertragen wird.

3. Vorrichtung zur Durchführung des Verfahrens nach Anspruch 1 umfassend eine Gateelektrodentreiberstufe (4), welche eine Speisungsüberwachungsschaltung (7), eine logische Auswerteschaltung (6), eine Treiberschaltung (8) und eine Entsättigungsüberwachungsschaltung (9) aufweist, wobei die Gateelektrodentreiberstufe (4) einen Schwellwertvergleicher (15) umfasst, **dadurch gekennzeichnet, dass** die Gateelektrodentreiberstufe (4) im Falle eines über die Speisungsüberwachungsschaltung (7) erfassten Speisungsausfalls und/oder im Falle einer über die Entsättigungsüberwachungsschaltung (9) erfassten Entsättigung des IGBT (12) zum selbstständigen Ansteuern des IGBT (12) derart ausgebildet ist, dass der IGBT (12) anwendungsabhängig in einen sicheren Schaltzustand versetzt wird.

4. Vorrichtung nach Anspruch 3, **dadurch gekennzeichnet, dass** die Gateelektrodentreiberstufe (4) optische Sendemittel (16) umfasst.

5. Vorrichtung nach Anspruch 4, **dadurch gekennzeichnet, dass** die optischen Sendemittel (16) eine Laserdiode oder eine Licht emittierende Diode aufweisen.

6. Vorrichtung nach Anspruch 3, **dadurch gekennzeichnet, dass** die Gateelektrodentreiberstufe ( 4) optische Empfangsmittel ( 5) umfasst.

7. Vorrichtung nach Anspruch 6, **dadurch gekennzeichnet, dass** die optischen Empfangsmittel ( 5) eine Photodiode aufweisen.

8. Vorrichtung nach Anspruch 4, **dadurch gekennzeichnet, dass** der Schwellwertvergleicher (15) mit den optischen Sendemitteln (16) verbunden ist.

## Claims

1. A method for controlling the switching state of a bipolar transistor with insulated gate electrode (IGBT) (12), said bipolar transistor being controlled by means of a gate electrode driver stage (4) applying the gate-emitter voltage (10), and the collector-emitter voltage (14) of said bipolar transistor serving for monitoring the desaturation of the IGBT (12), and a check-back signal (3, 3a) being transmitted from the gate electrode driver stage (4) to a master electronics, wherein the check-back signal (3) is formed from the collector-emitter voltage (14) of the IGBT (12), and wherein the check-back signal (3) is monitored with respect to an adjustable threshold value, **characterized in that**, in case of a desaturation of the IGBT (12) and/or in case of a power supply failure of the gate electrode driver stage (4), the IGBT (12) is independently controlled in such a way that the IGBT (12) is set into a safe switching state depending on the respective application.

2. The method according to Claim 1, in that the check-back signal is transmitted from the gate electrode driver stage (4) to the master electronics in the form of an optical check-back signal (3a).

3. A device for carrying out the method according to Claim 1, comprising a gate electrode driver stage (4) with a power supply monitoring circuit (7), a logic evaluation circuit (6), a driver circuit (8) and a desaturation monitoring circuit (9), wherein the gate electrode driver stage (4) comprises a threshold value comparator (15), **characterized in that**, in case of a power supply failure detected by means of the power supply monitoring circuit (7) and/or in case of a desaturation of the IGBT (12) detected by means of the desaturation monitoring circuit (9), the gate electrode driver stage (4) is realized in such a way that the IGBT (12) can be independently controlled, namely such that the IGBT (12) can be set into a safe switching state depending on the respective application.

4. The device according to Claim 3, **characterized in that** the gate electrode driver stage (4) comprises optical transmission means (16).

5. The device according to Claim 4, **characterized in that** the optical transmission means (16) comprise a laser diode or a light-emitting diode.

6. The device according to Claim 3, **characterized in that** the gate electrode driver stage (4) comprises optical reception means (5).

7. The device according to Claim 6, **characterized in that** the optical reception means (5) contain a photodiode.

8. The device according to Claim 4, **characterized in that** the threshold value comparator (15) is connected to the optical transmission means (16).

## Revendications

1. Procédé de contrôle de l'état de commutation d'un transistor bipolaire comportant une électrode de grille (IGBT) (12) disposée de manière isolée, qui est commandé au moyen d'un étage d'excitation d'électrode de grille (4) créant la tension grille-émetteur (4) et dont la tension collecteur-émetteur (14) sert à la surveillance de la désaturation de l'IGBT (12) et dans lequel un signal de rapport (3, 3a) est renvoyé par l'étage d'excitation d'électrode de grille (4) à une électronique directrice, le signal de rapport renvoyé (3) étant constitué à partir de la tension collecteur-émetteur (14) de l'IGBT (12) et le signal de rapport renvoyé (3) étant surveillé par rapport à une valeur de seuil réglable, **caractérisé en ce qu'**en cas de désaturation de l'IGBT (12) et/ou en cas d'une panne d'alimentation de l'étage d'excitation de l'électrode de grille (4), l'IGBT (12) est commandé de façon autonome de telle sorte que l'IGBT (12) soit mis en état de commutation sûr en fonction de l'application.

2. Procédé selon la revendication 1, **caractérisé en ce que** le signal de rapport renvoyé est transféré en forme d'un signal optique renvoyé (3a) par l'étage d'excitation d'électrode de grille (4) à l'électronique directrice.

3. Dispositif pour la mise en oeuvre du procédé selon la revendication 1 comprenant un étage d'excitation d'électrode de grille (4) qui présente un circuit de surveillance d'alimentation (7), un circuit d'exploitation logique (6), un circuit d'excitation (8) et un circuit de surveillance de désaturation (9), l'étage d'excitation d'électrode de grille (4) comprenant un comparateur de valeurs de seuil (15), **caractérisé en ce que** l'étage d'excitation d'électrode de grille (4) est, dans le cas d'une panne d'alimentation détectée par le circuit de surveillance d'alimentation (7) et/ou dans le cas d'une désaturation de l'IGBT (12) détectée par le circuit de surveillance de décharge (9), constitué pour la commande autonome de l'IGBT (12) de manière à ce que l'IGBT (12) soit mis en état de commutation sûr en fonction de l'application.

4. Dispositif selon la revendication 3, **caractérisé en ce que** l'étage d'excitation d'électrode de grille (4) comprend des moyens optiques d'émission (16).

5. Dispositif selon la revendication 4, **caractérisé en ce que** les moyens optiques d'émission (16) présentent une diode à laser ou une diode émettant de la lumière.

6. Dispositif selon la revendication 3, **caractérisé en ce que** l'étage d'excitation d'électrode de grille (4) comprend des moyens optiques de réception (5).

7. Dispositif selon la revendication 6, **caractérisé en ce que** les moyens optiques de réception (5) présentent une photodiode.

8. Dispositif selon la revendication 4, **caractérisé en ce que** le comparateur de valeurs de seuil (15) est relié aux moyens optiques d'émission (16).
